# EUROPÄISCHE PATENTSCHRIFT

(11) **EP 2 404 378 B1**
(45) Veröffentlichungstag und Bekanntmachung des Hinweises auf die Patenterteilung: **11.05.2016**
(21) Anmeldenummer: 10710192.5
(22) Anmeldetag: 05.03.2010
(51) Int. Cl.: H03K 17/96, H01L 41/113

(54) **ELEKTRISCHE BETÄTIGUNGSEINRICHTUNG ZUR VERWENDUNG IN SANITÄRBEREICH**
ELECTRIC ACTUATING DEVICE FOR USE IN THE SANITARY SECTOR
DISPOSITIF D'ACTIONNEMENT ÉLECTRIQUE DESTINÉ À ÊTRE UTILISÉ DANS LE SECTEUR SANITAIRE

(30) Priorität: 06.03.2009 DE 102009011558
(43) Veröffentlichungstag der Anmeldung: 11.01.2012
(73) Patentinhaber: Hansa Armaturen GmbH, 70567 Stuttgart (DE)
(72) Erfinder: KUNKEL, Horst, 70567 Stuttgart (DE); REICH, Erwin, 70569 Stuttgart (DE)
(74) Vertreter: Ostertag, Ulrich
(86) Internationale Anmeldenummer: PCT/EP2010/001385
(87) Internationale Veröffentlichungsnummer: WO 2010/099977

(56) Entgegenhaltungen:
- EP-A1- 0 638 508
- WO-A1-2007/120042
- DE-A1-102008 014 443
- US-A- 5 332 944
- US-A1- 2008 292 826

## Beschreibung

Die Erfindung betrifft eine elektrische Betätigungseinrichtung zur Verwendung im Sanitärbereich mit
a) einer transparenten Trägerplatte, die an einer dem Benutzer zugewandten Fläche mindestens ein Bedienfeld aufweist, das zur Auslösung einer Funktion von dem Benutzer berührt werden muss;
b) mindestens einem auf der vom Benutzer abgewandten Fläche der Trägerplatte angeordneten Sensor, der auf die Berührung des Bedienfelds anspricht und ein entsprechendes elektrisches Ausgangssignal erzeugt.

Elektrisch betätigte und/oder elektronisch gesteuerte Sanitärarmaturen gewinnen zunehmend an Beliebtheit. Sie kommen in ganz besonderem Ausmaß dem wachsenden Bedürfnis nach Komfort und ansprechendem Design der angesprochenen Verkehrskreise entgegen. Allerdings gibt es im Sanitärbereich das Problem, dass die Umgebungsbedingungen für eine elektrische Betätigungseinrichtung sehr ungünstig sind. Verbreitet werden als Sensoren berührungslose Sensoren wie beispielsweise kapazitive Sensoren oder nach dem Reflexionsprinzip arbeitende IR-Sensoren eingesetzt. Diese werden jedoch leicht durch Fremdfelder, Wasserfilme, Schaum, Fremdlicht oder sonstige Verunreinigungen gestört, so dass Fehlfunktionen nicht ausbleiben.

Nicht nur an die Funktionssicherheit elektrischer Betätigungseinrichtungen im Sanitärbereich werden hohe Anforderungen gestellt; sie sollten darüber hinaus ästhetisch ansprechend sowie leicht zu reinigen und zu pflegen sein.

Eine elektrische Betätigungseinrichtung der eingangs genannten Art ist aus der DE 20 2008 011 846 U1 bekannt. Hier ist die Betätigungseinrichtung in eine Duschwand integriert; als Sensoren sind explizit nur kapazitive Sensoren angesprochen. Diese weisen die oben geschilderten Nachteile auf.

Das Dokument US 5,332,944 offenbart eine beleuchtete piezoelektrische Betätigungseinrichtung.

Das Dokument WO 2007/120042 A1 offenbart einen in einem Gehäuse integrierten piezoelektrischen Berührungsschalter.

Aufgabe der vorliegenden Erfindung ist es, eine elektrische Betätigungseinrichtung der eingangs genannten Art zu schaffen, die nicht nur höchsten ästhetischen Ansprüchen gerecht wird sondern auch in den widrigen Umgebungsbedingungen im Sanitärbereich eine hohe Funktionssicherheit aufweist.

Diese Aufgabe wird erfindungsgemäß durch die elektrische Betätigungseinrichtung des Anspruchs 1 gelöst. Die erfindungsgemäße Einrichtung ist so ausgestaltet, dass
c) auf der vom Benutzer abgewandten Fläche der Trägerplatte gegenüber dem Bedienelement eine Vertiefung in der Trägerplatte vorgesehen ist, welche ganz oder zumindest überwiegend einen Vorsprung ringförmig umschließt, in welchem die Trägerplatte eine größere Wandstärke als im Bereich der Vertiefung aufweist;
d) der Sensor ein Kraft- oder Wegesensor ist, der mit einer Fläche gegen die Stirnfläche des Vorsprungs anliegt.

Erfindungsgemäß wird also als Sensor ein solcher eingesetzt, der auf eine vom Benutzer auf die ihm zugewandte Fläche der Trägerplatte ausgeübte Kraft oder die Bewegung eines benachbarten Bauteils anspricht. Bewusst wird auf eine berührungslos oder kraftlos arbeitendes System verzichtet. Die physikalische Kraft oder die Bewegung als den Parameter zu wählen, auf welchen der Sensor anspricht, hat den Vorteil, dass Umgebungseinflüsse, die beim Stand der Technik störend waren, wie insbesondere Licht, elektrische Felder und Verschmutzungen, wirkungslos bleiben. Die Geometrie der Trägerplatte mit einer im Wesentlichen ringförmigen Vertiefung und einem von dieser umgebenen Vorsprung dickerer Wandstärke, auf dem der Kraft- oder Wegesensor aufliegt, hat den Vorteil, dass die vom Benutzer auszuübende Kraft verstärkt auf den Kraft- oder Wegesensor übertragen wird. Es werden also nur sehr geringe Kräfte benötigt. Werden auf der selben Trägerplatte mehrere Bedienfelder vorgesehen, die unterschiedliche Funktionen auslösen können, wird durch die geschilderte Geometrie des einzelnen Bedienfelds ein "Übersprechen" von einem Bedienfeld zum anderen minimiert; dies bedeutet, dass durch Berührung der Trägerplatte an einem Bedienfeld nicht auch versehentlich die eigentlich vom zweiten Bedienfeld gesteuerte Funktion ausgelöst werden kann.
Eine erfindungsgemäße Betätigungseinrichtung kann vollständig eingegossen, also gegenüber Umwelteinflüssen vollständig abgekapselt werden.
Vorteilhafterweise umfasst der Kraft- oder Wegesensor ein Piezoelement. Derartige Piezoelemente sind preiswert im Handel erhältlich.

Erfindungsgemäß ist die Vertiefung mit einer Vergussmasse ausgegossen, die eine größere Elastizität als das Trägermaterial aufweist, aus dem die Trägerplatte besteht. Diese Vergussmasse kompensiert also die Schwächung der Trägerplatte im Bereich der Vertiefung, so dass hier keine erhöhte Bruchgefahr besteht. Aufgrund ihrer erhöhten Elastizität ändert diese Vergussmasse jedoch nichts daran, dass im Bereich der Vertiefung eine erhöhte Flexibilität der Trägerplatte besteht, welche eine Bewegung des umschlossenen Vorsprungs in Richtung auf den Kraft- oder Wegesensor erleichtert.

Aus optischen Gründen ist es besonders empfehlenswert, wenn die Vergussmasse einen optischen Brechungsindex aufweist, der demjenigen des Materials entspricht, aus dem die Trägerplatte besteht. In diesem Fall ist sowohl die ringförmige Vertiefung als auch die Vergussmasse für den Benutzer praktisch unsichtbar.

Als besonders geeignete Vergussmasse haben sich UV-aushärtende Avryle oder Epoxide herausgestellt.

Ein Ausführungsbeispiel der Erfindung wird nachfolgend anhand der Zeichnung näher erläutert; es zeigen
- Figur 1: einen Schnitt durch eine zwei Bedienfelder umfassende Betätigungseinrichtung für eine Sanitärarmatur;
- Figur 2: eine Detailvergrößerung aus Figur 1;
- Figur 3: die rückwärtige Ansicht einer transparenten Trägerplatte, die bei der Betätigungseinrichtung der Figur 1 Verwendung findet;
- Figur 4: in kleinerem Maßstab perspektivisch die Trägerplatte der Figur 3.

Die in der Zeichnung dargestellte und insgesamt mit dem Bezugszeichen 1 gekennzeichnet Betätigungseinrichtung ist vornehmlich zur Verwendung in Nassräumen gedacht und dient der elektrischen Ansteuerung einer Sanitärarmatur, beispielsweise um einen Wasserfluss auszulösen oder die Temperatur des ausfließenden Wassers zu verändern. Die Sanitärarmatur selbst, bei der es sich um Wasserauslaufarmaturen ebenso wie um Duschen oder Urinale handeln kann, ist in der Zeichnung ebensowenig dargestellt wie die elektronische Steuerung, welche die von der Betätigungseinrichtung 1 erzeugten elektrischen Signale verarbeitet. Hier können gewöhnliche, dem Fachmann bekannte Technologien eingesetzt werden.

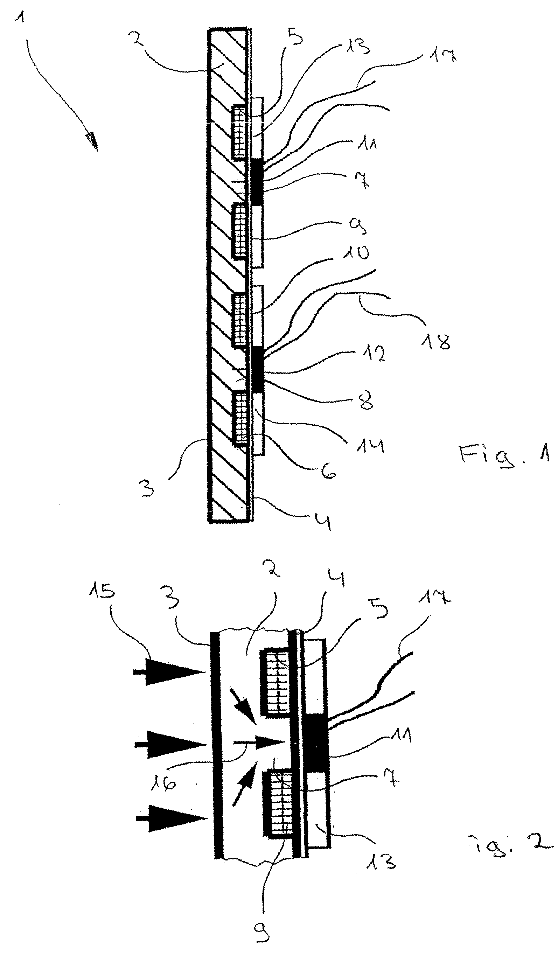

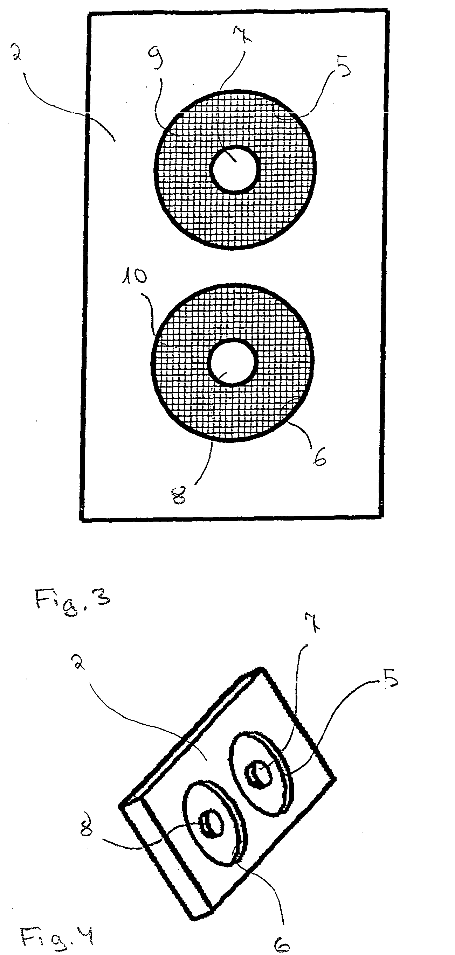

Die Betätigungseinrichtung 1 umfasst eine transparente, insbesondere aus Glas oder Acrylglas bestehende Trägerplatte 2, die so montiert wird, dass die in Figur 1 linke Seitenfläche 3 auf den Benutzer zu zeigt. In die gegenüberliegende, vom Benutzer abgewandte Seite 4 der Trägerplatte 2 sind zwei ringförmige Vertiefungen 5, 6 eingearbeitet, wie dies insbesondere den Figuren 3 und 4 zu entnehmen ist. Im Bereich der ringförmigen Vertiefungen 5, 6 ist die Wandstärke der Trägerplatte 2 reduziert und dadurch hier lokal ihre Flexibilität erhöht. In den Bereichen der von den ringförmigen Vertiefungen umgebenen Vorsprünge 7, 8 dagegen ist die Wandstärke der Trägerplatte 2 unverändert; hier liegt eine geringere Flexibilität vor.

Die ringförmigen Vertiefungen 5, 6 sind mit einem transparenten Material 9, 10 ausgegossen. Dieses wird so gewählt, dass es selbst eine größere Elastizität als das Material der Trägerplatte 2 aufweist, dass aber sein Brechungsindex möglichst nahe an denjenigen des Materials der Trägerplatte 2 herankommt. Auf diese Welse sind für den Benutzer, der die Betätigungseinrichtung 1 von der Seite 3 aus betrachtet, die ringförmigen Vertiefungen 5, 6 und das darin befindliche Vergussmaterial 9, 10 praktisch unsichtbar.

Die Betätigungseinrichtung 1 umfasst für jedes Betätigungsfeld, also für jede ringförmige Vertiefung 5, 6 mit dem von dieser jeweils umgebenen Vorsprung 7, 8 einen Kraftsensor 11, 12, der in der Lage ist, eine auf ihn ausgeübte mechanische Kraft in ein elektrisches Signal umzuwandeln und dieses Signal auf den schematisch dargestellten Ausgangsleitungen 17, 18 bereitzustellen. Als Kraftsensoren 11, 12 kommen insbesondere Piezoelemente in Frage, die im Handel erhältlich sind. Die Kraftsensoren 11, 12 werden durch ringförmige Halterungen 13, 14, die in geeigneter Weise unabhängig von der Trägerplatte 2 befestigt sind, in direkter Anlage an den Stirnflächen der Vorsprünge 7, 8 gehalten.

Die Funktionsweise der fertig installierten Betätigungseinrichtung 1 ist wie folgt:
Der Benutzer drückt mit einem oder mehreren Fingern, auf denjenigen Bereich der Fläche 3 der Trägerplatte 2, die einem der beiden Vorsprünge 7, 8 benachbart ist, vorzugsweise auf denjenigen Bereich, der radial innerhalb der entsprechenden ringförmigen Vertiefung 5, 6 liegt. Der entsprechende Bereich der Trägerplatte 2 kann entsprechend gekennzeichnet sein und/oder ein Symbol dafür tragen, welche Funktion mit der Berührung dieses Bereichs gesteuert werden kann. Diese Kraftbeaufschlagung durch den Benutzer ist in Figur 2 durch die Pfeile 15 angedeutet. Aufgrund der geringeren Wandstärke der Trägerplatte 2 im Bereich neben den ringförmigen Vertiefungen 5, 6 führt die Kraftbeaufschlagung zu einer Verbiegung der Trägerplatte 2 derart, dass der entsprechende Vorsprung 7, 8 im Sinn des Pfeils 16 der Figur 2 auf den entsprechenden Kraftsensor 11, 12 zu bewegt wird. Da dieser Kraftsensor 11, 12 durch die zugehörige Halterung 13, 14 im Wesentlichen raumfest gehalten wird, wird die Kraft des Benutzers, die aufgrund der beschriebenen Anordnung im Bereich der Stirnfläche des Vorsprungs 7, 8 verstärkt ist, auf den Kraftsensor 11, 12 übertragen. Dieser gibt nunmehr über die entsprechende Ausgangsleitung 17, 18 ein Signal an die elektronische Steuerung ab, die dann die gewünschte Funktion auslöst.

Durch das Vergussmaterial 9, 10 in den ringförmigen Vertiefungen 5, 6 wird die Gefahr verringert, dass die Trägerplatte 2 in den in der Wandstärke verringerten Bereichen neben den ringförmigen Vertiefungen 5, 6 bricht. Die Konzentration der Kraft, die vom Benutzer im Sinn der Pfeile 15 von Figur 2 auf die Trägerplatte 2 ausgeübt wird, führt zudem zu einer Übersprechdämpfung in dem Sinn, dass die Aufbringung einer Kraft durch den Benutzer im Bereich des einen Bedienfelds (z. B. im Bereich des in Figur 1 oberen Vorsprungs 7) irrtümlich auch zu einem Ansprechen des dem anderen Bedienfeld (im Bereich des Vorsprungs 8 von Figur 1) zugehörigen Kraftsensors 12 führt.

Die gesamte Betätigungseinrichtung 1 kann hermetisch abgeschlossen werden, beispielsweise durch entsprechendes Vergießen, wobei dann nur die Ausgangsleitungen 17, 18 aus der Betätigungseinrichtung 1 herausgeführt sind. Die Betätigungseinrichtung 1 ist dann eine wasserdichte Baugruppe, der weder eine hohe Luftfeuchtigkeit, wie sie gerade in Nassräumen vorkommt, noch eine direkte Beaufschlagung mit Wasser Schaden zufügen kann.

Statt der in einer gesonderten Halterung befestigten, auf eine lineare Kraft ansprechenden Kraftsensoren 11, 12; die bei dem oben beschriebenen Ausführungsbeispiel eingesetzt wurden, können auch flache, folienartige Sensoren verwendet werden, die direkt ohne weiter Halterung auf den Stirnseiten der Vorsprünge aufgebrcht werden und die sich bei Kraftbeaufschlagung verbiegen.

In das Vergussmaterial kann bei Wunsch auch ein Leuchtmittel mit eingegossen werden, das von einer übergeordneten Steuerung z.B. als Betätigungskontrolle angesteuert wird.

Ästhetisch interessant sind auch opake Vergussmaterialien. Wenn in diese ein Leuchtmittel eingegossen ist, wird die gesamte ringförmige Vertiefung homogen ausgeleuchtet.

Schließlich ist es noch möglich, auf der Oberseite der Trägerplatte eine Verspiegelung als Sichtschutz anzubringen, die auch transluzent sein kann.

## Patentansprüche

1. Elektrische Betätigungseinrichtung zur Verwendung im Sanitärbereich mit
a) einer flexiblen, transparenten Trägerplatte (2), die an einer dem Benutzer zugewandten Fläche (3) mindestens ein Bedienfeld aufweist, das zur Auslösung einer Funktion von dem Benutzer berührt werden muss;
b) mindestens einem auf der vom Benutzer abgewandten Fläche der Trägerplatte (2) angeordneten Sensor (11, 12), der auf die Berührung des Bedienfelds anspricht und ein entsprechendes elektrisches Ausgangssignal erzeugt;
wobei
c) der Sensor (11, 12) ein Kraft- oder Wegesensor ist, der mit einer Fläche gegen die Stirnfläche eines Vorsprungs (7, 8) anliegt;
d) auf der vom Benutzer abgewandten Fläche (4) der Trägerplatte (2) gegenüber dem Bedienfeld eine Vertiefung (5, 6) in der Trägerplatte (2) vorgesehen ist, welche ganz oder zumindest überwiegend den Vorsprung (7, 8) ringförmig umschließt, in welchem die Trägerplatte (2) eine größere Wandstärke als im Bereich der Vertiefung (5, 6) aufweist;
e) die Vertiefung (5, 6) mit einer Vergussmasse (9, 10) ausgegossen ist, die eine größere Elastizität als das Material aufweist, aus dem die Trägerplatte (2) besteht.

2. Betätigungseinrichtung nach Anspruch 1, **dadurch gekennzeichnet, dass** der Kraftsensor (11, 12) ein Piezoelement umfasst.

3. Betätigungseinrichtung nach Anspruch 1 oder 2, **dadurch gekennzeichnet, dass** die Vergussmasse (9, 10) einen optischen Brechungsindex aufweist, der demjenigen des Materials entspricht, aus dem die Trägerplatte (2) besteht.

4. Betätigungseinrichtung nach einem der Ansprüche 1 bis 3, **dadurch gekennzeichnet, dass** die Vergussmasse (9, 10) UV-aushärtendes Acryl oder Epoxid ist.

## Claims

1. Electric actuating apparatus for use in the sanitary sector, having:
a) a flexible, transparent carrier plate (2) which has, on a surface (3) facing towards the user, at least one control panel which has to be touched by the user for the purpose of triggering a function;
b) at least one sensor (11, 12) which is arranged on the surface of the carrier plate (2) facing away from the user and which responds to the touching of the control panel and generates a corresponding electrical output signal;
wherein
c) the sensor (11, 12) is a force sensor or distance sensor which rests, with one surface, against the end face of a projection (7, 8);
d) there is provided opposite the control panel, on the surface (4) of the carrier plate (2) facing away from the user, a depression (5, 6) in said carrier plate (2) which surrounds the projection (7, 8), either completely or at least predominantly, in the form of a ring, in which projection the carrier plate (2) has a greater wall thickness than in the region of the depression (5, 6); and
e) the depression (5, 6) is filled with a sealing compound which has greater elasticity than the material of which the carrier plate (2) consists.

2. Actuating apparatus according to Claim 1, **characterised in that** the force sensor (11, 12) comprises a piezo element.

3. Actuating apparatus according to Claim 1 or 2, **characterised in that** the sealing compound (9, 10) has an optical refractive index which corresponds to that of the material of which the carrier plate (2) consists.

4. Actuating apparatus according to one of Claims 1 to 3, **characterised in that** the sealing compound (9, 10) is UV-curing acrylic or epoxy.

## Revendications

1. Dispositif d'actionnement électrique conçu pour être utilisé dans le domaine sanitaire, comprenant
a) une platine de support (2) flexible, transparente et munie, sur une surface (3) tournée vers l'utilisateur, d'au moins un panneau de commande devant nécessairement être touché par ledit utilisateur, en vue de déclencher une fonction ;
b) au moins un capteur (11, 12) disposé sur la surface de ladite platine de support - (2) qui est tournée à l'opposé dudit utilisateur, lequel capteur réagit au toucher dudit panneau de commande et engendre un signal électrique de sortie correspondant ;
sachant
c) que le capteur (11, 12) est un capteur de forces ou de courses en applique, par une surface, contre la face extrême d'une protubérance (7, 8) ;
d) qu'un renfoncement (5, 6) prévu dans la platine de support (2) en vis-à-vis dudit panneau de commande, sur la surface (4) de ladite platine de support (2) qui pointe à l'opposé de l'utilisateur, ceinture annulairement l'intégralité ou, pour le moins, la majeure partie de ladite protubérance (7, 8) dans laquelle ladite platine de support (2) présente une plus grande épaisseur de paroi que dans la région dudit renfoncement (5, 6) ;
e) que ledit renfoncement (5, 6) est comblé par une masse de scellement (9, 10) douée d'une élasticité supérieure à celle du matériau dont ladite platine de support (2) est constituée.

2. Dispositif d'actionnement selon la revendication 1, **caractérisé par le fait que** le capteur de forces (11, 12) inclut un élément piézo-électrique.

3. Dispositif d'actionnement selon la revendication 1 ou 2, **caractérisé par le fait que** la masse de scellement (9, 10) présente un indice de réfraction optique correspondant à celui du matériau dont la platine de support (2) est constituée.

4. Dispositif d'actionnement selon l'une des revendications 1 à 3, **caractérisé par le fait que** la masse de scellement (9, 10) est un acrylique ou un époxyde durcissable aux UV.
